# EUROPEAN PATENT APPLICATION

(11) **EP 4 686 563 A1**
(43) Date of publication of application: **04.02.2026**
(21) Application number: 25192358.7
(22) Date of filing: 29.07.2025
(51) Int. Cl.: B41F 15/08, B23K 3/06, B41F 15/36, B41F 15/40, H05K 3/12

(54) **SOLDER PASTE TUBE ASSEMBLY DEVICE, PRINTING MACHINE COMPRISING SAME, AND SOLDER PASTE TUBE ASSEMBLY METHOD**

(30) Priority: 31.07.2024 CN 202411049188
(71) Applicant: Illinois Tool Works Inc., Glenview IL 60025 (US)
(72) Inventor: CHENG, Zaizai, Glenview, 60025 (US); ZHU, Hong, Glenview, 60025 (US)
(74) Representative: HGF

(57) **Abstract**

The present disclosure provides a solder paste tube assembly device, a printing machine comprising same and a solder paste tube assembly method. The solder paste tube assembly device is used for securing and sealing a solder paste tube, in which a nozzle is arranged at the bottom of the solder paste tube, and the solder paste tube provides a solder paste by means of the nozzle, the solder paste tube assembly device comprises a support, a top sealing device and a bottom support device, the top sealing device is configured to controllably ascend and descend for connecting to the top of the solder paste tube at different heights in a sealing manner. The solder paste tube assembly device of the present disclosure can automatically complete the disassembly and replacement of the solder paste tubes and can automatically replace the solder paste tubes of different heights by means of the top sealing device capable of automatically ascending and descending.

## Description

### TECHNICAL FIELD

The present disclosure relates to the technical field of stencil printing systems, and in particular to a solder paste tube assembly device, a printing machine comprising same, and a solder paste tube assembly method.

### BACKGROUND

During manufacturing of surface-mounted printed circuit boards, a printing machine may be configured to squeeze out a solder paste from a solder paste tube and then print the solder paste onto a circuit board, allowing electronic elements to be subsequently deposited onto the circuit board. A circuit board with a conductive surface is transferred into the printing machine, and is properly aligned from below with an aperture on a stencil of the printing machine by means of one or more small holes or marks (called "fiducials") on the circuit board. After the circuit board is aligned with the stencil in the printing machine, the solder paste is squeezed out from the solder paste tube onto the stencil, and a scraper of the printing machine is then moved against an upper surface of the stencil to force the solder paste through the aperture in the stencil to the conductive surface of the circuit board.

In general, a sealing device is connected to the top of the solder paste tube to seal the solder paste inside the solder paste tube. A nozzle for squeezing out the solder paste is arranged at the bottom of the solder paste tube. When the solder paste in the solder paste tube is used up and the solder paste tube needs to be replaced, it is often necessary to disassemble the sealing device on the top of the solder paste tube. After a new solder paste tube is replaced, the top of the new solder paste tube is sealed again.

### SUMMARY OF THE DISCLOSURE

A first aspect of the present disclosure provides a solder paste tube assembly device for securing and sealing a solder paste tube, in which a nozzle is arranged at the bottom of the solder paste tube, and the solder paste tube provides a solder paste by means of the nozzle, the solder paste tube assembly device comprises a support, a top sealing device and a bottom support device, the top sealing device is assembled at the top of the support, the top sealing device comprises a sealing assembly, and the sealing assembly is configured to connect to the top of the solder paste tube in a sealing manner. The bottom support device is assembled at the bottom of the support, the bottom support device comprises a support seat, and the support seat is configured to support the nozzle of the solder paste tube. The top sealing device is configured to controllably ascend and descend for connecting to the top of the solder paste tube at different heights in a sealing manner.

According to the first aspect, the bottom support device is configured to controllably ascend and descend such that the top of the solder paste tube disengages from the sealing assembly by reducing the height of the nozzle of the solder paste tube.

According to the first aspect, the sealing assembly comprises an annular boss and a sealing ring, wherein the sealing ring is sleeved around the outer edge of the annular boss, and the annular boss is used for protruding into the top of the solder paste tube to be connected to the solder paste tube by means of the sealing ring in a sealing manner.

According to the first aspect, the top sealing device comprises an air cylinder sliding block and a guide rod, wherein the guide rod extends in a height direction, the air cylinder sliding block is configured to ascend and descend in an extension direction of the guide rod, and the sealing assembly is connected to the air cylinder sliding block.

According to the first aspect, the bottom support device comprises an air cylinder and a push rod, wherein the push rod extends in a height direction, the push rod is configured to be actuated by the air cylinder and extend out or retract in the height direction, and the support seat is connected to the push rod.

According to the first aspect, the solder paste tube assembly device further comprises a control device and a sensor group. The sensor group is connected to the support, and the sensor group is configured to detect a state of the solder paste tube and provide a corresponding signal to the control device, wherein the control device is configured to control at least one of the top sealing device and the bottom support device to ascend and descend on the basis of the signal provided by the sensor group.

According to the first aspect, the solder paste tube comprises a squeezing element. The sensor group comprises an empty tube position sensor, the empty tube position sensor is arranged at a corresponding position where the squeezing element is located at an empty tube position, and the empty tube position sensor is configured to provide an empty tube signal to the control device when it is detected that the squeezing element reaches the empty tube position.

According to the first aspect, the sensor group further comprises an early warning position sensor, the early warning position sensor is arranged at a corresponding position where the squeezing element is located at an early warning position, and the early warning position sensor is configured to provide an early warning signal to the control device when it is detected that the squeezing element reaches the early warning position.

According to the first aspect, the sensor group further comprises an additional sensor, the additional sensor is configured to detect whether there is the solder paste tube in the solder paste tube assembly device.

A second aspect of the present disclosure provides a printing machine, comprises a solder paste tube assembly device according to any one of the first aspect and a workbench. The solder paste tube assembly device is connected to the workbench and is capable of moving relative to the workbench in a first direction, a second direction or a third direction, the third direction is a height direction.

A third aspect of the present disclosure provides a solder paste tube assembly method, comprises: replacing an old solder paste tube with a new solder paste tube. The step of replacing an old solder paste tube with a new solder paste tube comprises: moving a top sealing device on the basis of a height of the new solder paste tube; assembling the new solder paste tube and ascending a bottom support device such that a sealing assembly is connected to the top of the new solder paste tube in a sealing manner.

According to the third aspect, the solder paste tube assembly method further comprises: detecting whether there is an old solder paste tube; releasing, if there is the old solder paste tube, the old solder paste tube first; and then replacing the old solder paste tube with a new solder paste tube; and mounting, if there is no old solder paste tube, the new solder paste tube.

According to the third aspect, the step of releasing the old solder paste tube comprises: descending the bottom support device such that the sealing assembly disengages from the top of the old solder paste tube; and removing the old solder paste tube.

Other features, advantages, and embodiments of the present application will be set forth or become apparent from the following detailed description, the accompanying drawings, and the claims. Furthermore, it should be understood that the above summary of the invention and the following detailed description are merely exemplary and are intended to provide further explanation, without limiting the scope of the present disclosure. However, the detailed description and specific examples only illustrate the preferred embodiments of the present disclosure. It will be apparent to those skilled in the art that various variations and modifications within the spirit and scope of the present disclosure will become evident from the specific embodiments.

### BRIEF DESCRIPTION OF THE DRAWINGS

FIG. 1 is a structural perspective diagram of a printing machine according to an embodiment of the present disclosure;
FIG. 2A is a structural perspective diagram of a printing head in FIG. 1 from one perspective;
FIG. 2B is a structural perspective diagram of the printing head in FIG. 2A from another perspective;
FIG. 2C is an exploded view of the printing head in FIG. 2A;
FIG. 2D is a sectional view of the printing head in FIG. 2A;
FIG. 3 shows a structural block diagram of a control device in FIG. 1;
FIGS. 4A-1 to 4A-3 show a process of releasing an old solder paste tube;
FIGS. 4B-1 to 4B-3 show a process of replacing the old solder paste tube with a new solder paste tube;

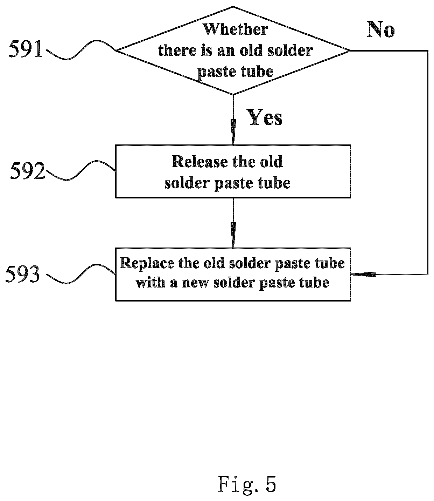

FIG. 5 shows a flow chart of a solder paste tube assembly method;

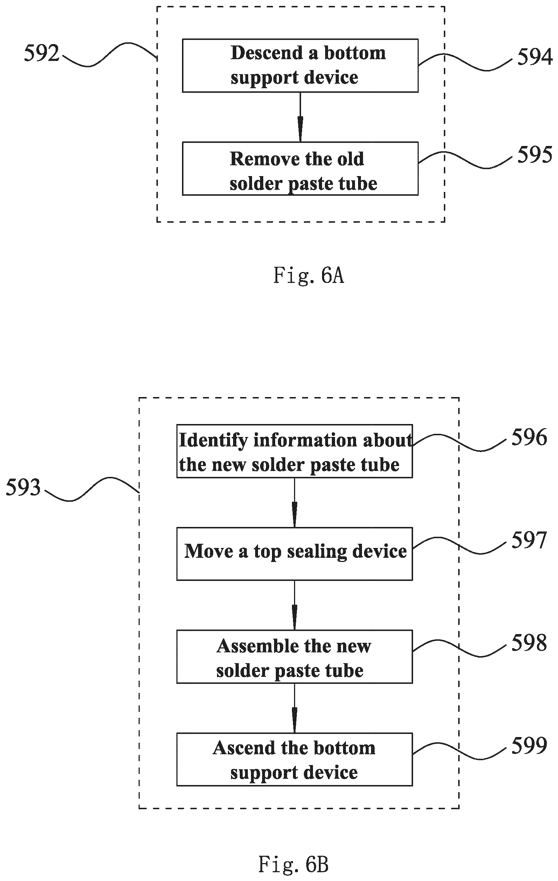

FIG. 6A shows a flow chart of releasing the old solder paste tube in the assembly method of FIG. 5; and
FIG. 6B shows a flow chart of replacing the old solder paste tube with the new solder paste tube in the assembly method of FIG. 5.

### DETAILED DESCRIPTION OF EMBODIMENTS

Various specific embodiments of the present disclosure will be described below with reference to the drawings which form part of this specification. It is to be understood that although the terms indicating orientations, such as "front", "rear", "upper", "lower", "left", "right", are used in the present disclosure to describe orientations of structural parts and elements in various examples of the present disclosure, these terms are used herein only for ease of illustration and are determined based on the exemplary orientations shown in the accompanying drawings. Since the arrangements in the embodiments disclosed in the present disclosure may be in various directions, these terms indicating directions are only illustrative and should not be considered as limitations. Wherever possible, the same or similar reference numerals used in this disclosure refer to the same components.

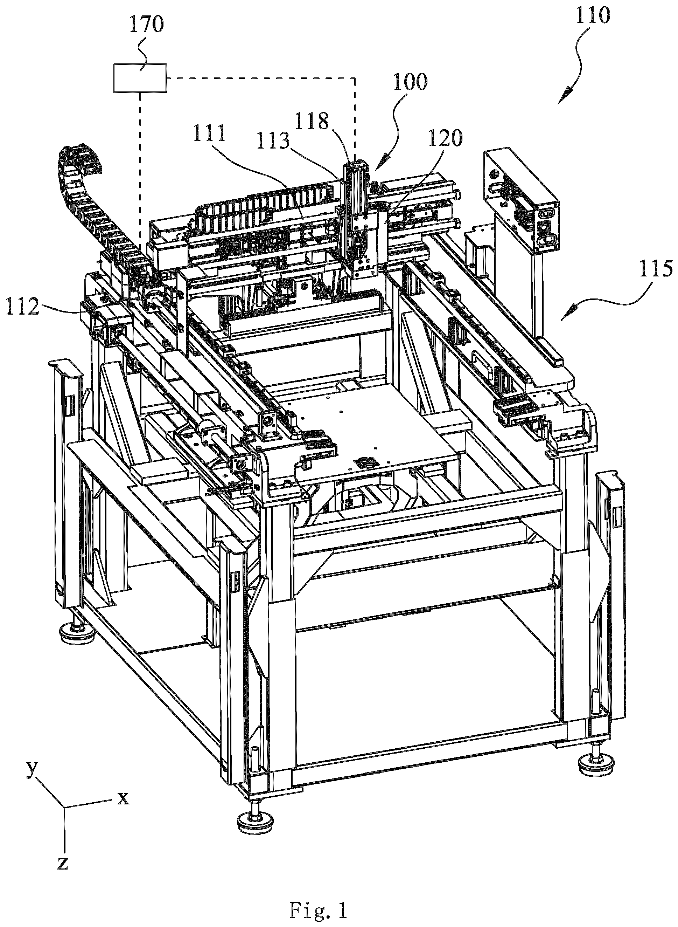

FIG. 1 shows a general structure of a printing machine 110. As shown in FIG. 1, the printing machine 110 comprises a printing head 100 and a workbench 115. The printing head 100 comprises a solder paste tube 120 and a solder paste assembly device 118 for securing and sealing the solder paste tube 120. The solder paste assembly device 118 is connected to the workbench 115 and moves on the workbench 115 to align the solder paste tube 120 on the solder paste assembly device 118 with a spot on a stencil that needs to be printed. Specifically, the workbench 115 comprises an x-direction (i.e., first direction) movement mechanism 111, a y-direction (i.e., second direction) movement mechanism 112, and a z-direction (i.e., third direction) movement mechanism 113. The printing head 100 is connected to the z-direction (i.e. third direction or height direction) movement mechanism 113 to enable the printing head 100 to ascend and descend relative to the workbench 115 in a z-direction. Also, the printing head 100 is connected to the x-direction (i.e., first direction) movement mechanism 111 to enable the printing head 100 to move left and right relative to the workbench 115 in an x-direction. The x-direction movement mechanism 111 is connected to the y-direction (i.e., second direction) movement mechanism 112 to enable the x-direction (i.e., first direction) movement mechanism 111 to move together with the printing head 100 back and forth in a y-direction. Those skilled in the art should understand that a structure of the workbench may be configured specifically depending on the type of the printing machine. It should be noted that the first direction x, the second direction y, and the third direction z herein are substantially perpendicular to one another.

The printing machine 110 further comprises a control device 170. The control device 170 can be communicatively connected to the workbench 115 to control a specific position of the printing head 100 by controlling movement actions of the movement mechanisms on the workbench 115, so as to align the solder paste tube 120 with the spot on the stencil that needs to be printed. In the present disclosure, the control device 170 is also communicatively connected to the printing head 100 to control an assembly action of the printing head 100, so as to control the solder paste tube 120 to be controllably assembled to the solder paste assembly device 118. The specific assembly action will be described in detail below.

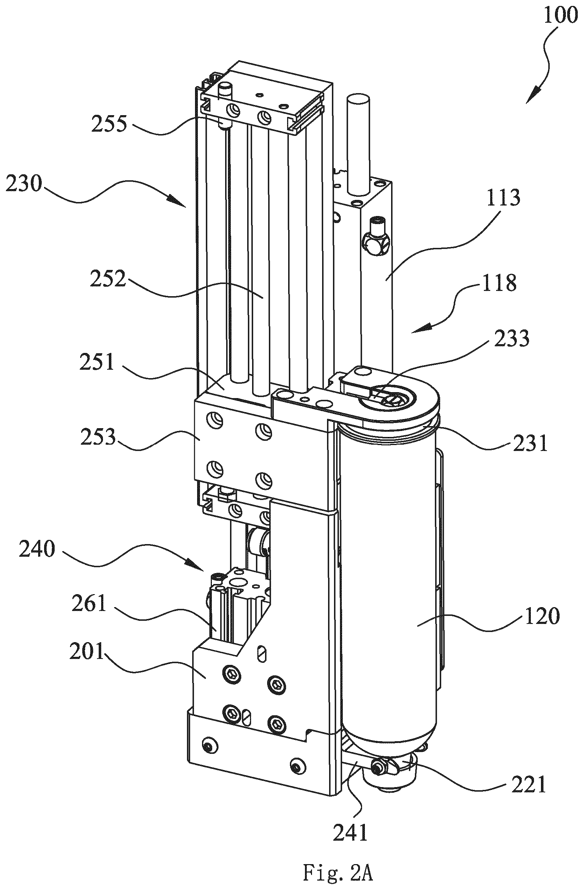

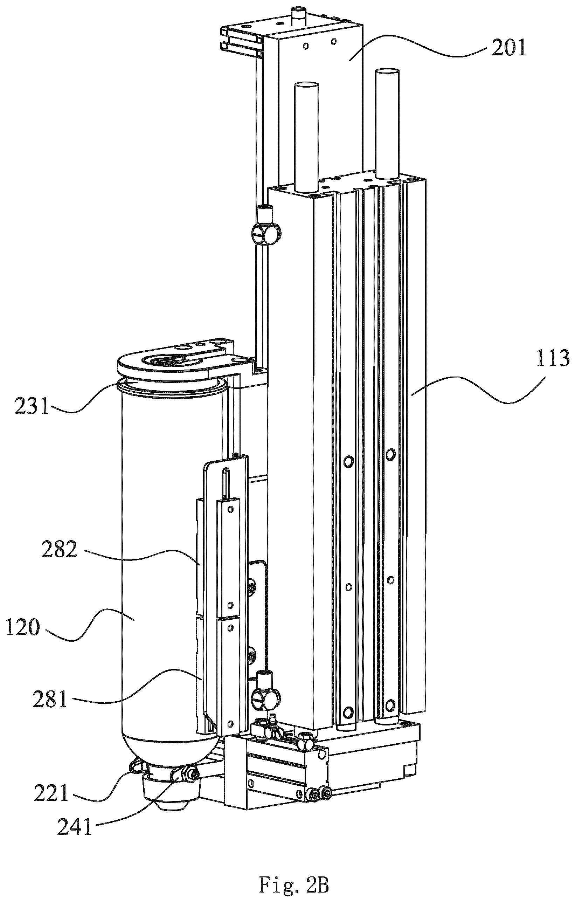

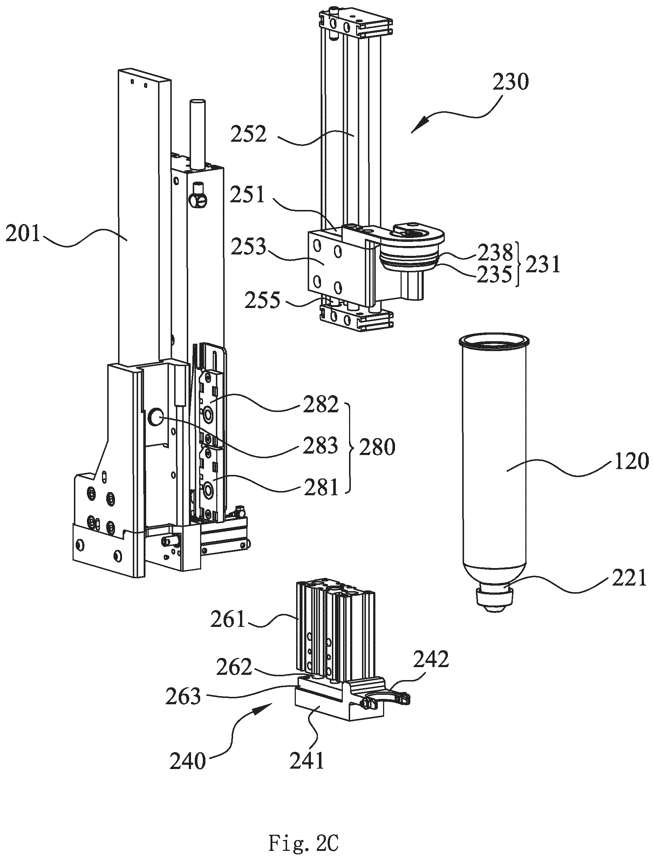

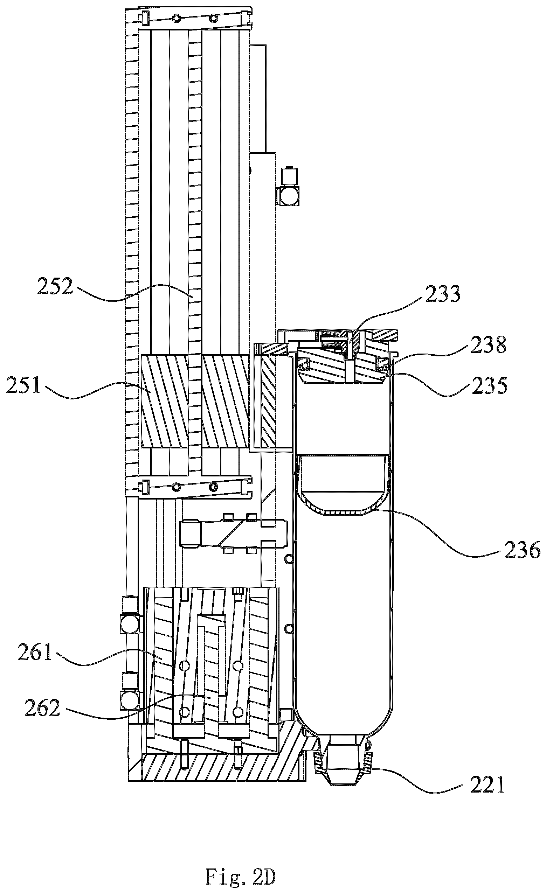

FIGS. 2A to 2D show a specific structure of the printing head. FIG. 2A shows a structural perspective diagram of the printing head 100 when viewed from left to right, and FIG. 2B shows a structural perspective diagram of the printing head 100 when viewed from right to left, to illustrate a general structure of the printing head 100. FIG. 2C shows an exploded view of the printing head 100 to illustrate specific structures of a top sealing device 230 and a bottom support device 240. FIG. 2D shows a sectional view of the printing head 100 taken in a height direction at the solder paste tube 120 to illustrate a specific structure of the solder paste tube 120.

As shown in FIGS. 2A and 2B, the solder paste tube 120 is in a shape of a hollow tube. The top of the solder paste tube 120 is opened, and a nozzle 221 is arranged at the bottom of the solder paste tube 120. The bottom of the nozzle 221 is opened to enable the solder paste tube 120 to provide a solder paste by means of the nozzle 221. The solder paste assembly device 118 further comprises a support 201, the top sealing device 230 and the bottom support device 240. The top sealing device 230 and the bottom support device 240 are arranged on the left side of the support 201, the z-direction movement mechanism 113 is arranged on the right side of the support 201, and the solder paste tube 120 is arranged on the front side of the support 201 and is provided at a position corresponding to that of the top sealing device 230 and the bottom support device 240. The z-direction movement mechanism 113 is securely connected to the support 201, such that the z-direction movement mechanism 113 drives the entire printing head 100 to ascend and descend by driving the support 201 to ascend and descend in the z-direction.

The top sealing device 230 is assembled on the top of the support 201 and can be controlled by the control device 170 to ascend and descend in the height direction. The top sealing device 230 comprises a sealing assembly 231, and the sealing assembly 231 can be connected to the top of the solder paste tube 120 in a sealing manner. As the top sealing device 230 ascends and descends, the sealing assembly 231 can press against the top of the solder paste tube 120 to seal the solder paste tube 120 or leave from the top of the solder paste tube 120. Also, as the top sealing device 230 ascends and descends, the sealing assembly 231 can be connected to the top of the solder paste tube 120 at different heights in a sealing manner.

The bottom support device 240 is assembled at the bottom of the support 201. The bottom support device 240 comprises a support seat 241, and the support seat 241 is used for supporting the nozzle 221 of the solder paste tube 120. In this embodiment, the bottom support device 240 can also be controlled by the control device 170 to ascend and descend in the height direction. The support seat 241 holds and supports the nozzle 221 of the solder paste tube 120. Therefore, when the bottom support device 240ascends and descends, the solder paste tube 120 can accordingly ascend and descend. When the top sealing device 230 remain stationary, the up-and-down movement of the solder paste tube 120 enables the top of the solder paste tube 120 to leave from the sealing assembly 231 or to reconnect to the sealing assembly 231 in a sealing manner.

Thus, the sealing assembly 231 can be connected to solder paste tubes of different heights in a sealing manner by means of the coordinated up-and-down movements of the top sealing device 230 and the bottom support device 240. In some embodiments, it is also possible that only the top sealing device 230 ascends and descends, and the bottom support device 240 is stationary, as long as the top sealing device have more up/down positions.

As shown in FIG. 2C, the sealing assembly 231 comprises an annular boss 235 and a sealing ring 238. The sealing ring 238 is sleeved around the outer edge of the annular boss 235. When the sealing assembly 231 is connected to the top of the solder paste tube 120 in a sealing manner, the annular boss 235 can protrude into the top of the solder paste tube 120, and the sealing ring 238 can abut against a side wall of the solder paste tube 120, such that the sealing ring 238 is connected to the solder paste tube 120 in a sealing manner.

Those skilled in the art should understand that the top sealing device 230 and bottom support device 240 may be configured as any structure capable of controllably moving up and down. As an example, the top sealing device 230 and the bottom support device 240 each comprise a commercially available air cylinder structure. Specifically, the top sealing device 230 comprises an air cylinder sliding block 251 and a guide rod 252. The guide rod 252 extends in the height direction. The guide rod 252 is connected to the support 201 to remain stationary, and the air cylinder sliding block 251 is sleeved on the guide rod 252 and is configured to slide in an extension direction of the guide rod 252 toascend and descend. The sealing assembly 231 is connected to the air cylinder sliding block 251, such that the movement of the air cylinder sliding block 251 can cause the movement of the sealing assembly 231. In this embodiment, the sealing assembly 231 is arranged on the front side of the air cylinder sliding block 251 to locate at a position corresponding to that of the solder paste tube 120. The top sealing device 230 further comprises a connecting block 253. The connecting block 253 connects the air cylinder sliding block 251 and the sealing assembly 231. Thus, the up-and-down movement of the air cylinder sliding block 251 can cause the up-and-down movement of the sealing assembly 231, such that the sealing assembly 231 can be connected to the top of the solder paste tube 120 in a sealing manner or leave from the top of the solder paste tube 120.

The bottom support device 240 comprises an air cylinder 261 and a push rod 262. The push rod 262 extends in the height direction. The air cylinder 261 is connected to the support 201 to remain stationary, and the push rod 262 can extend out or retract relative to the air cylinder 261 in the height direction. The support seat 241 is connected to the push rod 262, such that the movement of the push rod 262 can cause the movement of the support seat 241. In this embodiment, the bottom support device 240 further comprises a connecting block 263. The connecting block 263 is connected to the bottom of the push rod 262, and the connecting block 263 connects the push rod 262 and the support seat 241. Thus, the extension or retraction of the push rod 262 can cause an up-and-down movement of the support seat 241, such that the solder paste tube 120 can ascend and descend. In this embodiment, the support seat 241 further comprises a fork portion 242. The fork portion 242 protrudes outwardly from the front side of the support seat 241 to locate at a position corresponding to that of the nozzle 221 of the solder paste tube 120, the fork portion 242 can tightly clamp the nozzle 221, and accordingly the up-and-down movement of the support seat 241 can cause the movement of the solder paste tube 120.

In this embodiment, the top sealing device 230 may further comprise a limiting member 255. The limiting member 255 is used for limiting a position of the air cylinder sliding block 251 on the guide rod 252. This position can be set manually according to the height of the solder paste tube 120 to be assembled, such that the sealing assembly 231 can be adapted to solder paste tubes 120 of various heights. As an example, the limiting member 255 comprises two limiting members arranged at the top and bottom of the support 201, such that the solder paste assembly device 118 in this embodiment can be adapted to the solder paste tubes 120 of two different heights. When the air cylinder sliding block 251 abuts against the two limiting members, the air cylinder sliding block 251 cannot continue to move upward or downward. In other embodiments, it is possible to set other numbers of limiting members 255 or other positions thereof according to requirements. Moreover, in this embodiment, the push rod 262 of the bottom support device 240 has an extended position and a retracted position to drive the support seat 241 to ascend and descend between a first position and a second position corresponding thereto, the height of the first position is lower, and the height of the second position is higher.

Further, as shown in FIG. 2D, the hollow tubular solder paste tube 120 is used for storing the solder paste, and when used, the solder paste is controllably discharged from the nozzle 221 at the bottom of the solder paste tube 120. In this embodiment, a squeezing element 236 is arranged in the solder paste tube 120. The solder paste is stored between the squeezing element 236 and the nozzle 221. The control device 170 can control the nozzle 221 to discharge the solder paste by controlling the squeezing element 236 to move toward the nozzle 221. When the squeezing element 236 is connected to the top of the solder paste tube 120, the solder paste tube 120 is in a full tube state, and the squeezing element 236 is in a full tube position. As the squeezing element 236 moves downward, when the squeezing element 236 moves to the nozzle 221, the solder paste is almost completely discharged from the solder paste tube 120, the solder paste tube 120 is in an empty tube state, and the squeezing element 236 is in an empty tube position. In a state as shown in FIG. 2D, the squeezing element 236 is in an early warning position between the empty tube position and the full tube position. When the squeezing element 236 is in the early warning position, the solder paste in the solder paste tube 120 is substantially in a half tube state. In some embodiments, the early warning position of the squeezing element 236 may be set according to actual requirements or may not be set. In this embodiment, the middle portion of the squeezing element 236 is recessed downward such that when the squeezing element 236 is in the full tube position, the middle portion of the squeezing element 236 can leave a space for the annular boss 235 of the sealing assembly 231 to protrude into the solder paste tube 120. Also, the shape of the bottom of the squeezing element 236 is set to the same as that of the bottom of the solder paste tube 120, such that when the squeezing element 236 moves to the empty tube position, the solder paste inside the solder paste tube 120 can be almost completely discharged.

As an example, an air duct 233 is also arranged on the sealing assembly 231. The air duct 233 runs through the annular boss 235 to introduce an air flow into the solder paste tube 120. In this embodiment, the air flow is introduced over the squeezing element 236. The air flow introduced over the squeezing element 236 increases a pressure over the squeezing element 236, thereby forcing the squeezing element 236 to move downward. The control device 170 controls the squeezing element 236 to move toward the nozzle 221 by controlling the air flow introduced into the solder paste tube 120 through the air duct 233.

As shown in FIGS. 2A to 2D, the solder paste assembly device 118 further comprises a sensor group 280. The sensor group 280 is connected to the support 201 and is communicatively connected to the control device 170. The sensor group 280 is configured to detect a state of the solder paste tube 120 and provide a corresponding signal to the control device 170. The control device 170 controls actions of individual devices, such as the up-and-down movement of the top sealing device 230 and/or the up-and-down movement of the bottom support device 240, on the basis of the signal provided by the sensor group 280. Specifically, the sensor group 280 comprises an empty tube position sensor 281, an early warning position sensor 282 and an additional position sensor 283. The empty tube position sensor 281 and the early warning position sensor 282 are arranged on the right side of the solder paste tube 120 for detecting a position of the squeezing element 236 inside the solder paste tube 120. In this embodiment, the early warning position sensor 282 is arranged above the empty tube position sensor 281. Specifically, the empty tube position sensor 281 is arranged at a position corresponding to the empty tube position of the squeezing element 236 and is configured to provide an empty tube signal to the control device 170 when it is detected that the squeezing element 236 reaches the empty tube position. The early warning position sensor 282 is arranged at a position corresponding to the early warning position of the squeezing element 236 and is configured to provide an early warning signal to the control device 170 when it is detected that the squeezing element 236 reaches the early warning position. The additional position sensor 283 is arranged on the rear side of the solder paste tube 120 for detecting whether there is the solder paste tube 120 in the solder paste tube assembly device 118. Those skilled in the art should understand that the solder paste typically needs to be stored under refrigeration but used at room temperature. Therefore, the solder paste tube needs to be taken out of a refrigeration device in advance during replacement, and can be used after a period of standing time at room temperature. The early warning position sensor 282 is configured to prompt the control device 170 that a new solder paste tube to be replaced can be taken out in advance, to improve the efficiency of replacing the solder paste tube 120. In some embodiments, the sensor group 280 may also not comprise the early warning position sensor 282. In some embodiments, the sensor group 280 may further comprise a two-dimensional code identification device, etc., and a corresponding two-dimensional code is arranged on the solder paste tube 120. The two-dimensional code identification device is configured to identify the two-dimensional code on the solder paste tube 120 to receive parameter information such as height and capacity of the solder paste tube 120. The control device 170 controls the devices on the basis of the parameter information. A control process of the control device 170 on the basis of the signal detected by the sensor group 280 will be described in detail below.

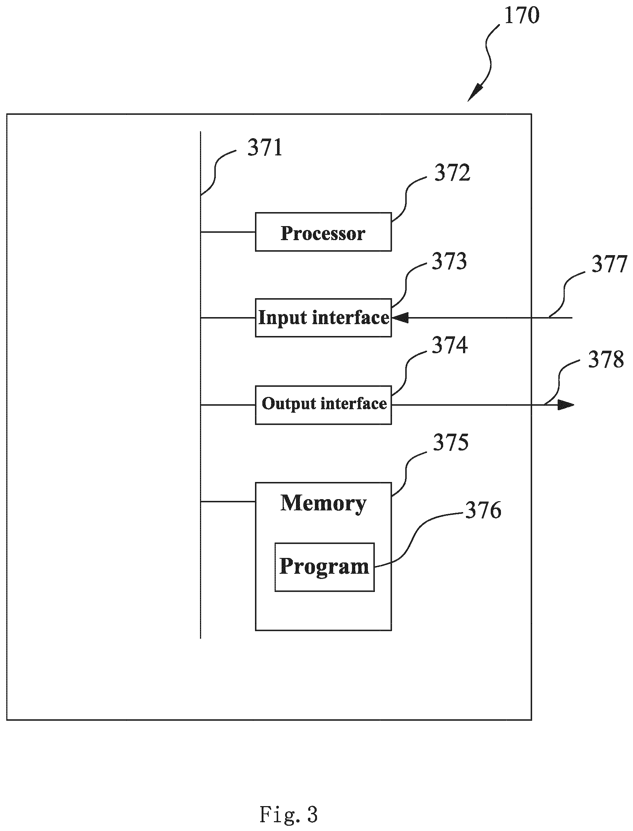

FIG. 3 shows a structural block diagram of the control device 170. As shown in FIG. 3, the control device 170 comprises a bus 371, a processor 372, an input interface 373, an output interface 374, and a memory 375 having a control program 376. The components in the control device 170, including the processor 372, the input interface 373, the output interface 374 and the memory 375, are communicatively connected to the bus 371, such that the processor 372 can control operations of the input interface 373, the output interface 374 and the memory 375. Specifically, the memory 375 is configured to store programs, instructions and data, and the processor 372 reads the programs, instructions and data from the memory 375 and can write data to the memory 375. The processor 372 controls the operations of the input interface 373 and the output interface 374 by executing the programs and the instructions read from the memory 375.

As shown in FIG. 3, the input interface 373 is communicatively connected to the sensor group 280, an external apparatus, etc., by means of a connection 377, to receive various signals and information provided by the sensor group 280 or various input instructions provided by the external apparatus, and store these signals, information or instructions in the memory 375. The output interface 374 is communicatively connected to the top sealing device 230 and the bottom support device 240 by means of a connection 378. In some embodiments, the output interface 374 is also communicatively connected to the x-direction (i.e., first direction) movement mechanism 111, the y-direction (i.e., second direction) movement mechanism 112 and the z-direction (i.e., third direction) movement mechanism 113 on the workbench 115 by means of the connection 378. By executing the program 376 in the memory 375, the control device 170 controls the up-and-down movements of the air cylinder sliding block 251 of the top sealing device 230 and the air cylinder 261 of the bottom support device 240, and controls the movement position of the printing head 100 relative to the workbench 115. In addition, the control device 170 is also communicatively connected to an air supply device (not shown) to control the amount of the solder paste squeezed out from the solder paste tube 120.

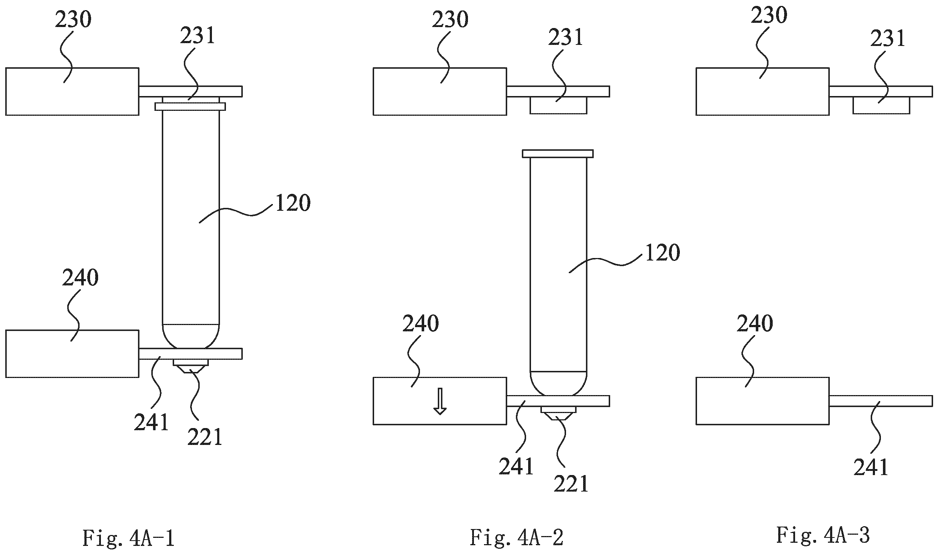

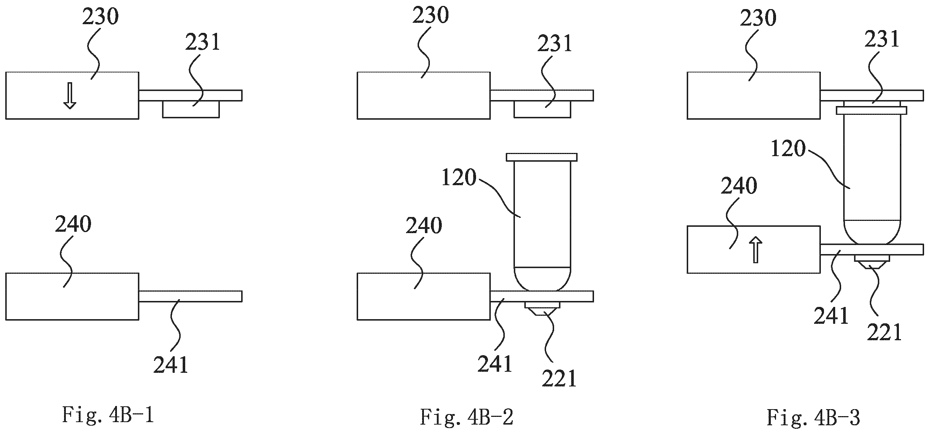

FIGS. 4A and 4B show a process of replacing the solder paste tube 120 by the solder paste tube assembly device 118, to illustrate the coordinated up-and-down movement process of the top sealing device 230 and the bottom support device 240. FIG. 4A shows a process of releasing the old solder paste tube, and FIG. 4B shows a process of replacing the old solder paste tube with the new solder paste tube.

As shown in FIG. 4A-1, the top of the solder paste tube 120 is tightly pressed and sealed by the sealing assembly 231 of the top sealing device 230, and the nozzle 221 of the solder paste tube 120 is supported on the support seat 241 of the bottom support device 240, such that the solder paste tube assembly device 118 assembles the solder paste tube 120 in place. In this case, a distance between the top sealing device 230 and the bottom support device 240 is substantially equal to the height of the solder paste tube 120. The control device 170 can squeeze out the solder paste from the solder paste tube 120 until the empty tube position sensor 281 detects that the solder paste tube 120 is in the empty tube state. When the control device 170 detects that the old solder paste tube is in the empty tube state and that the old solder paste tube needs to be replaced with the new solder paste tube, the top sealing device 230 remains stationary, and the bottom support device 240 is descended, such that the support seat 241 and the nozzle 221 of the old solder paste tube descend along with the bottom support device 240, and the sealing assembly 231 disengages from the top of the old solder paste tube until the solder paste tube assembly device 118 reaches a position shown in FIG. 4A-2.

As shown in FIG. 4A-2, the distance between the top sealing device 230 and the bottom support device 240 is greater than the height of the old solder paste tube. Although the top sealing device 230 remains stationary, the sealing assembly 231 no longer seals the old solder paste tube due to the descending movement of the bottom support device 240. However, the support seat 241 of the bottom support device 240 still holds and supports the nozzle 221 of the old solder paste tube, so that the old solder paste tube is still connected in the solder paste tube assembly device 118. In this case, an operator can manually disassemble the old solder paste tube or push the old solder paste tube according to specific settings of the printing machine to detach the old solder paste tube from the support seat 241. The solder paste tube assembly device 118 reaches a position as shown in FIG. 4A-3.

As shown in FIG. 4A-3, both the top sealing device 230 and the bottom support device 240 remain stationary, and the distance between the devices is still greater than the height of the old solder paste tube. After the old solder paste tube is detached, the additional position sensor 283 detects and confirms that there is no solder paste tube on the solder paste tube assembly device 118, and the replacement of the old solder paste tube with the new solder paste tube can then begin according to the process of FIG. 4B. The control device 170 obtains height data of the new solder paste tube by identifying a two-dimensional code on the new solder paste tube by means of the two-dimensional code identification device, or the control device 170 receives the height data of the new solder paste tube input by the operator. When the height data of the new solder paste tube is less than height data of the old solder paste tube, the bottom support device 240 remains stationary and the top sealing device 230 descends to a position shown in FIG. 4B-1.

As shown in FIG. 4B-1, the top sealing device 230 descends to a height corresponding to the new solder paste tube. The "height corresponding to" herein refers to a position to which the top sealing device 230 descends, at this position, the sealing assembly 231 of the top sealing device 230 can be connected to the top of the new solder paste tube in a sealing manner when the bottom support device 240 is ascended to the highest position. In this case, the bottom support device 240 still remains in a descended state, and therefore the distance between the bottom support device 240 and the top sealing device 230 is greater than the height of the new solder paste tube. In this case, the operator can manually assemble the new solder paste tube, or push the new solder paste tube onto the support seat 241 according to the specific settings of the printing machine, such that the nozzle 221 of the new solder paste tube is supported on the support seat 241. The solder paste tube assembly device 118 reaches a position shown in FIG. 4B-2.

As shown in FIG. 4B-2, the distance between the bottom support device 240 and the top sealing device 230 is still greater than the height of the new solder paste tube. The nozzle 221 of the new solder paste tube is supported on the support seat 241, but the sealing assembly 231 of the top sealing device 230 is at a distance from the top of the new solder paste tube, such that the sealing assembly 231 has not yet sealed the top of the new solder paste tube. After the new solder paste tube is assembled in place, the top sealing device 230 remains stationary, and the bottom support device 240 ascends together with the new solder paste tube, such that the solder paste tube assembly device 118 reaches a position shown in FIG. 4B-3.

As shown in FIG. 4B-3, the distance between the bottom support device 240 and the top sealing device 230 is substantially equal to the height of the new solder paste tube. The sealing assembly 231 of the top sealing device 230 is reconnected to the top of the new solder paste tube in a sealing manner, and the bottom support device 240 supports the nozzle 221 of the new solder paste tube, such that the new solder paste tube is assembled in place on the solder paste tube assembly device 118.

Those skilled in the art should understand that, when the height of the new solder paste tube is the same as the height of the old solder paste tube, the new solder paste tube can be directly assembled without the up-and-down movement of the top sealing device 230 after the old solder paste tube is disassembled. Similarly, when the height of the new solder paste tube is greater than the height of the old solder paste tube, the top sealing device 230 can be ascend after the old solder paste tube is disassembled, and the new solder paste tube is then assembled according to the processes shown in FIG. 4B-2 and FIG. 4B-3.

FIG. 5 shows part of a flow chart of a method for assembling the solder paste tube assembly device 118. As shown in FIG. 5, in step 591, the control device 170 first identifies whether there is an old solder paste tube on the solder paste tube assembly device 118.

If there is the old solder paste tube, step 592 is performed, and the old solder paste tube is released in step 592. Then, step 593 is performed, and the old solder paste tube is replaced with the new solder paste tube in step 593.

If there is no old solder paste tube, step 593 is directly performed.

FIG. 6A shows a more specific flow chart of step 592, and FIG. 6B shows a more specific flow chart of step 593.

As shown in FIG. 6A, in step 592, the control device 170 first performs step 594. In step 594, the control device 170 descends the bottom support device 240 such that the old solder paste tube disengages from the sealing assembly 231. Then, step 595 is performed.

In step 595, the old solder paste tube is removed, for example, manually by the operator or automatically by control device 170.

As shown in FIG. 6B, in step 593, the control device 170 first performs step 596. In step 596, the control device 170 automatically identifies information about the new solder paste tube or the manually input information about the new solder paste tube. Then, step 597 is performed.

In step 597, the control device 170 moves the top sealing device 230 on the basis of the information about the new solder paste tube, such that the position of the top sealing device 230 corresponds to the height of the new solder paste tube. Then, step 598 is performed.

In step 598, the new solder paste tube is assembled, for example, manually by the operator or automatically by the control device 170. Then, step 599 is performed.

In step 599, the control device ascends the bottom support device 240 such that the sealing assembly 231 of the top sealing device 230 can be reconnected to the top of the new solder paste tube in a sealing manner.

Thus, the solder paste tube assembly device 118 of the present disclosure can automatically complete the disassembly and replacement of solder paste tubes of various heights.

In some printing machines, it may be necessary to replace the solder paste tube according to the specific operating status of the printing machine. The solder paste tube assembly device of the present disclosure can automatically complete the disassembly and replacement of solder paste tubes and can automatically mount solder paste tubes of different heights by means of the top sealing device capable of automatically ascending and descending.

In addition, by means of the coordinated movements of the top sealing device and the bottom support device, the solder paste tube assembly device of the present disclosure reduces ascending positions to be set for the top sealing device and the bottom support device and simplifies ascending/descending structures of the top sealing device and the bottom support device.

Moreover, the solder paste tube assembly device of the present disclosure further improves the level of automation of the printing machine by providing the sensor group, so that when the printing machine is in an unobservable working state, the operations of the printing head and the solder paste tube can be better monitored.

Although the present disclosure is described with reference to the examples of the embodiments outlined above, various alternatives, modifications, variations, improvements and/or substantial equivalents, whether are known or can be anticipated at present or to be anticipated in future, may be obvious to those of at least ordinary skill in the art. Further, the technical effects and/or technical problems in this specification are exemplary rather than limiting. Therefore, the disclosed content in this specification may solve other technical problems and have other technical effects. Accordingly, the examples of the embodiments of the present disclosure as set forth above are intended to be illustrative rather than limiting. Various changes may be made without departing from the spirit or scope of the present disclosure. Therefore, the present disclosure is intended to encompass all known or earlier disclosed alternatives, modifications, variations, improvements, and/or substantial equivalents.

## Claims

1. A solder paste tube assembly device for securing and sealing a solder paste tube (120), in which a nozzle (221) is arranged at the bottom of the solder paste tube (120), and the solder paste tube (120) provides a solder paste by means of the nozzle (221), the solder paste tube assembly device (118) comprising:
a support (201);
a top sealing device (230), the top sealing device (230) being assembled at the top of the support (201), the top sealing device (230) comprising a sealing assembly (231), and the sealing assembly (231) is configured to connect to the top of the solder paste tube (120) in a sealing manner; and
a bottom support device (240), the bottom support device (240) being assembled at the bottom of the support (201), the bottom support device (240) comprising a support seat (241), and the support seat (241) is configured to support the nozzle (221) of the solder paste tube (120);
wherein the top sealing device (230) is configured to controllably ascend and descend for connecting to the top of the solder paste tube (120) at different heights in a sealing manner.

2. The solder paste tube assembly device according to claim 1, wherein
the bottom support device (240) is configured to controllably ascend and descend such that the top of the solder paste tube (120) disengages from the sealing assembly (231) by reducing the height of the nozzle (221) of the solder paste tube (120).

3. The solder paste tube assembly device according to claim 1, wherein
the sealing assembly (231) comprises an annular boss (235) and a sealing ring (238), wherein the sealing ring (238) is sleeved around the outer edge of the annular boss (235), and the annular boss (235) is used for protruding into the top of the solder paste tube (120) to be connected to the solder paste tube (120) by means of the sealing ring (238) in a sealing manner.

4. The solder paste tube assembly device according to claim 1, wherein
the top sealing device (230) comprises an air cylinder sliding block (251) and a guide rod (252), wherein the guide rod (252) extends in a height direction, the air cylinder sliding block (251) is configured to ascend and descend in an extension direction of the guide rod (252), and the sealing assembly (231) is connected to the air cylinder sliding block (251).

5. The solder paste tube assembly device according to claim 2, wherein
the bottom support device (240) comprises an air cylinder (261) and a push rod (262), wherein the push rod (262) extends in a height direction, the push rod (262) is configured to be actuated by the air cylinder (261) and extend out or retract in the height direction, and the support seat (241) is connected to the push rod (262).

6. The solder paste tube assembly device according to claim 2, further comprising:
a control device (170); and
a sensor group (280), the sensor group (280) being connected to the support (201), and the sensor group (280) being configured to detect a state of the solder paste tube (120) and provide a corresponding signal to the control device;
wherein the control device (170) is configured to control at least one of the top sealing device (230) and the bottom support device (240) to ascend and descend on the basis of the signal provided by the sensor group (280).

7. The solder paste tube assembly device according to claim 6, wherein
the solder paste tube (120) comprises a squeezing element (236); and
the sensor group (280) comprises an empty tube position sensor (281), the empty tube position sensor (281) being arranged at a corresponding position where the squeezing element (236) is located at an empty tube position, and the empty tube position sensor (281) being configured to provide an empty tube signal to the control device (170) when it is detected that the squeezing element (236) reaches the empty tube position.

8. The solder paste tube assembly device according to claim 7, wherein
the sensor group (280) further comprises an early warning position sensor (282), the early warning position sensor (282) being arranged at a corresponding position where the squeezing element (236) is located at an early warning position, and the early warning position sensor (282) being configured to provide an early warning signal to the control device (170) when it is detected that the squeezing element (236) reaches the early warning position.

9. The solder paste tube assembly device according to claim 7, wherein
the sensor group (280) further comprises an additional sensor (283), the additional sensor (283) being configured to detect whether there is the solder paste tube (120) in the solder paste tube assembly device (118).

10. A printing machine, comprising:
a solder paste tube assembly device (118) of any one of claims 1-9; and
a workbench (115);
wherein the solder paste tube assembly device (118) is connected to the workbench (115) and is capable of moving relative to the workbench (115) in a first direction (x), a second direction (y) or a third direction (z), the third direction (z) being a height direction.

11. A solder paste tube assembly method, comprising the steps:
replacing an old solder paste tube with a new solder paste tube, wherein the step of replacing an old solder paste tube with a new solder paste tube comprises:
moving a top sealing device (230) on the basis of a height of the new solder paste tube;
assembling the new solder paste tube; and
ascending a bottom support device (240) such that a sealing assembly (231) is connected to the top of the new solder paste tube in a sealing manner.

12. The solder paste tube assembly method according to claim **11,** further comprising:
detecting whether there is an old solder paste tube;
releasing, if there is the old solder paste tube, the old solder paste tube first, and then replacing the old solder paste tube with a new solder paste tube; and
mounting, if there is no old solder paste tube, the new solder paste tube.

13. The solder paste tube assembly method according to claim 12, wherein
the step of releasing the old solder paste tube comprises:
descending the bottom support device (240) such that the sealing assembly (231) disengages from the top of the old solder paste tube; and
removing the old solder paste tube.
